# EUROPEAN PATENT SPECIFICATION

(11) **EP 0 930 381 B1**
(45) Date of publication and mention of the grant of the patent: **05.11.2003**
(21) Application number: 99300124.7
(22) Date of filing: 07.01.1999
(51) Int. Cl.: C30B 15/36, C30B 15/00, C30B 29/06

(54) **Method of producing a silicon monocrystal**
Verfahren zur Herstellung eines Silizium-Einkristalles
Procédé de préparation d'un monocristal de silicium

(30) Priority: 14.01.1998 JP 1776598
(43) Date of publication of application: 21.07.1999
(73) Proprietor: SHIN-ETSU HANDOTAI COMPANY LIMITED, Chiyoda-ku Tokyo (JP)
(72) Inventor: Iino, Eiichi, c/o Isobe R & D Center, Annaka-shi, Gunma-ken (JP)
(74) Representative: Cooper, John

(56) References cited:
- EP-A- 0 671 491
- EP-A- 0 747 512
- PATENT ABSTRACTS OF JAPAN vol. 098, no. 001, 30 January 1998 & JP 09 235186 A (SUMITOMO SITIX CORP), 9 September 1997
- PATENT ABSTRACTS OF JAPAN vol. 098, no. 001, 30 January 1998 & JP 09 249493 A (SUMITOMO SITIX CORP), 22 September 1997

## Description

### BACKGROUND OF THE INVENTION

### Field of the Invention

The present invention relates to a method of manufacturing a silicon monocrystal in accordance with Czochralski method (CZ method) in which a silicon monocrystal ingot is grown with performing necking using a silicon seed crystal (hereinafter occasionally referred to as "a seed crystal").

### Description of the Related Art

In the conventional method of producing a silicon monocrystal according to CZ method, a seed crystal which is a silicon monocrystal is brought into contact with silicon melt and is then slowly pulled while being rotated in order to grow a silicon monocrystal ingot below the seed crystal. In the method, in order to eliminate slip dislocation caused by propagation of dislocation generated in the seed crystal in high density due to thermal shock, a neck portion having a smaller diameter as approximately 3 mm is formed after the silicon seed is brought into contact with a silicon melt, namely so called necking is performed. Subsequently, the diameter of the crystal is increased to be a predetermined value, and then a dislocation-free silicon monocrystal can be pulled. The above-mentioned necking operation is well known as Dash Necking method, which is a common method for pulling a silicon monocrystal ingot according to CZ method.

The seed crystal conventionally used is in a cylindrical shape having a diameter of approximately 8 to 20 mm or a prismatic shape having a side length of approximately 8 to 20 mm, wherein a cut-away portion or notch is formed thereon for attachment to a seed crystal holder, and a shape of a tip or lower end thereof to be brought into contact with a silicon melt first is flat. To pull a heavy monocrystal ingot safely, the thickness of the seed crystal cannot be smaller than above-described range in light of strength of the material.

In the seed crystal having such a shape, slip dislocation generates in high density, since a heat capacity of the tip end which is brought into contact with a silicon melt is large, so that a temperature difference generates rapidly in the crystal as soon as the seed crystal is brought into contact with the silicon melt, resulting in generation of slip dislocation in high density. Accordingly, the above-mentioned necking operation is necessary to eliminate slip dislocation in the monocrystal.

However, in the above mentioned method, a minimum diameter of the neck has to be decreased to approximately 4 to 6 mm in order to eliminate the dislocation, even when choosing the necking condition appropriately. Such a small diameter is insufficient in strength to support a monocrystal ingot such as produced in recent years, which has been getting heavier with increase of a diameter thereof. This may lead to a serious accident such that the fine neck portion is broken while the monocrystal ingot is pulled and the monocrystal ingot falls.

To solve the above-mentioned problems, the applicant proposed inventions as disclosed in Japanese Patent Application Laid-open (kokai) No. 5-139880 and No.9-255485 (Japanese Patent Application No. 8-87187). In these inventions, a seed crystal having a wedge or hollow tip end is used to reduce as much slip dislocation which is generated when the seed crystal is brought into contact with a silicon melt as possible, so that dislocation can be eliminated even when the neck portion is relatively thick, and thereby the strength of the neck portion can be improved.

According to the method, strength of the neck portion can be improved to some extent, since the neck portion can be formed to be thick. However, even in the method, it is necessary to perform necking operation and to form a neck portion in which slip dislocation is present. Furthermore, the neck portion has to be thicker for production of an ingot which is larger in a diameter and longer such as those produced in recent years. For example, the diameter of the neck portion has to be 5 mm at least in order to pull a monocrystal ingot having a weight of 200 kg or more, or the strength may be insufficient. Accordingly, these inventions cannot solve the problems fundamentally.

Another problem in the necking method using the seed having the special shape of the tip end mentioned above relates to rate of success in making a crystal dislocation free. When the elimination of dislocation results in failure in the above-mentioned method, the seed crystal has to be exchanged to perform the method again. Accordingly, improvement in the rate of success in making a crystal dislocation free is especially important in the method. Elimination of dislocation cannot be achieved with a thick neck. According to a conventional necking method, when a diameter of a neck is more than 6 - 7 mm, elimination of dislocation can be hardly achieved.

EP-A-0671491 discloses a method of growing silicon crystals using a cylindrical or prismatic seed crystal in which a seed taper portion is grown from the seed crystal, then a cylindrical neck portion is grown. The length of the seed taper is 2.5 to 15 times the diameter or side length of the seed crystal and the neck diameter is in the range 0.09 to 0.9 times the diameter or side length of the seed crystal.

The inventors studied the cause of a lowering of the rate of success in making a crystal dislocation free, and found that control of the factors which have been controlled in the conventional methods, such as the shape of the seed crystal, a temperature maintaining time during which the seed crystal is held above melt surface, a melting speed, the crystal growth rate or the like is not sufficient for improvement in rate of success in making a crystal dislocation free, and the reproducibility is low in such a method.

### SUMMARY OF THE INVENTION

The present invention has been accomplished to solve the above-mentioned previous problems. An object of the present invention is to provide a method of producing a silicon monocrystal which enables growing of a monocrystal ingot without lowering rate of success in making a crystal dislocation free in the case of using a seeding method wherein a thick neck is formed, and thereby improves productivity of a heavy silicon monocrystal having a large diameter.

To achieve the above mentioned object, the present invention relates to a method of producing a silicon monocrystal which comprises preparing a silicon seed crystal having a sharp tip end, and melting down a part of the silicon seed crystal from the tip end to a position having a predetermined thickness, followed by performing a necking operation to form a tapered necking part and a cylindrical neck portion, and subsequently pulling a monocrystal ingot after increasing a diameter, characterised in that: a diameter or a side length of a body of said seed crystal is 14 mm or more; said part of the seed crystal to be melted down is a part from the tip end to a position in which the thickness is twice as large as the diameter of the neck portion to be formed or more; said necking operation is initiated within 5 minutes after said part of the silicon seed crystal is melted down into the melt; and said necking operation is performed in such a way that the tapered necking part is formed at an early stage by pulling a crystal with its diameter gradually decreasing to a minimum diameter of 5 mm or more, then forming the neck portion, and subsequently increasing the diameter of the crystal and pulling the monocrystal ingot.

As described above, thermal shock is decreased by using a silicon seed crystal having a sharp tip end, and melting the lower part of the seed crystal than a position in which a thickness is twice as large as the diameter of the neck portion to be formed or more, the necking operation is performed in such a way that a tapered necking part in the shape of a cone is formed at an early stage by pulling the crystal with gradually decreasing the diameter to a minimum diameter of 5 mm or more, and then a neck portion is formed, followed by pulling a monocrystal ingot after increasing a diameter, and thus a slip dislocation is reduced efficiently due to presence of the tapered necking part, even when the neck is thick, so that rate of success in making a crystal dislocation free and reproducibility thereof is improved. Accordingly, the method of the present invention can provide a neck portion having the desired diameter, and thus copes with the tendency of the monocrystal ingot to be larger and heavier, and can achieve improvement in productivity and cost reduction.

When there is used the silicon seed crystal of which a body is in a cylindrical shape having a diameter of 14 mm or more, a square rod shape having a side length of 14 mm or more, or a polygonal rod shape wherein a diameter of the inscribed circle in section is 14 mm or more as described above, the tapered necking part sufficient for elimination of slip dislocation can be formed between the seed crystal and the neck portion even if the diameter of the neck portion is thick as 5 mm or more. Accordingly, the method can cope with the tendency of the monocrystal ingot to be large and heavier.

When the necking operation is initiated within 0 - 5 minutes after a part of the silicon seed crystal is melted down into the melt, slip dislocation hardly generates or is hardly increased after melting down so that rate of success in making a crystal dislocation free can be further improved. When the seed crystal is held on the surface of the high temperature melt for a period longer than 5 minutes, additional slip dislocation may generate, or slip dislocation may increase while the silicon seed crystal is held at high temperature even in the case that only few slip dislocation has generated while the seed crystal is brought into contact with the melt.

As described above, according to the present invention, rate of success in making a crystal dislocation free of approximately 90 % or more can be achieved, good reproducibility and long stability can also be enabled, when the seeding method of thick necking is peformed in the method of pulling a silicon monocrystal ingot by Czochralski method. Accordingly, the method of the present invention can cope with the future tendency of the monocrystal ingot to be of a larger diameter, and longer and heavier, and can achieve improvement in productivity and cost reduction.

### BRIEF DESCRIPTION OF THE DRAWINGS

Fig. 1 is an explanatory view showing a method of the present invention wherein a thick neck portion is formed.
Fig. 2 is a graph showing a relation between holding time after melting down of the seed crystal and slip dislocation density.

### DESCRIPTION OF THE INVENTION AND EMOBDIMENT

The present invention and embodiments thereof will now be described. However, the invention is not limited thereto.

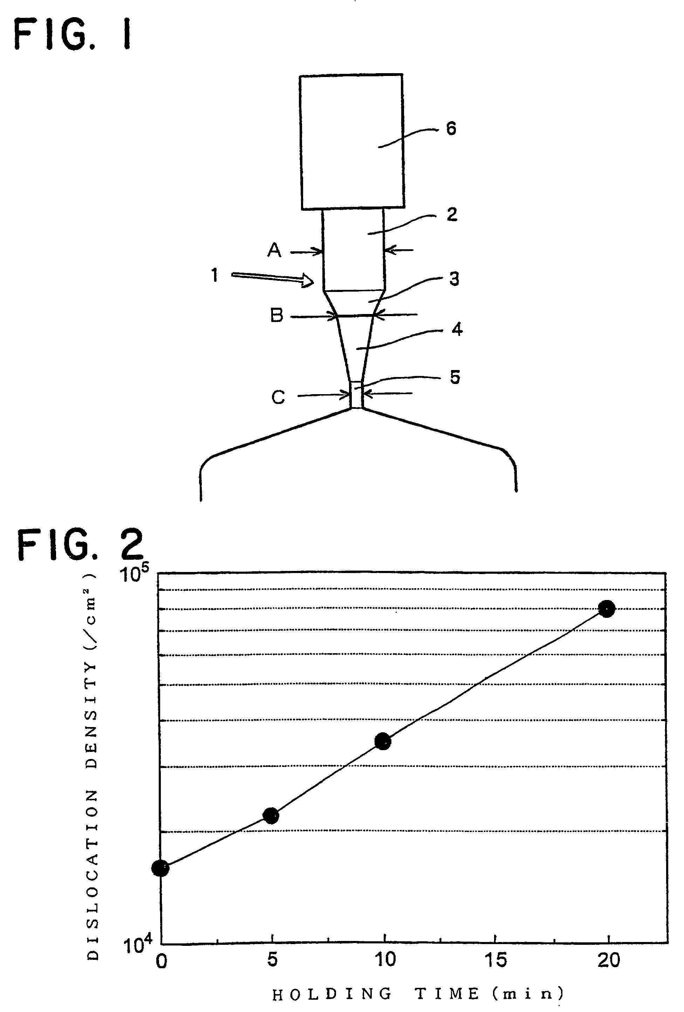

Fig.1 is explanatory view showing a method of the present invention wherein a thick neck portion is formed.

The inventors of the present invention have studied a cause of failing in achieving sufficient rate of success in making a crystal dislocation free and reproducibility, on formation of a thick neck portion (herein occasionally referred to as thick necking) in a seeding method with performing a necking operation in the method of growing a silicon monocrystal ingot, and have found that the cause of generating slip dislocation is closely related to a diameter of a lowest part of a seed crystal after a tip end of the seed crystal is melted, a diameter of a neck portion, a shape of the tapered necking part, a period after melting down of the seed crystal until a necking operation is initiated (holding time) or the like, and further studied these condition to accomplish the present invention.

First, the inventors picked up the factors which have been controlled in conventional methods, made experiments for the factors repeatedly, and defined a condition for elimination of dislocation as described below. The following factors, which are also shown in Table 1, were studied: a diameter of a body of a seed crystal (A), a diameter of the lower end of the seed crystal after the tip end is melted (B), a holding time after melting down of the seed crystal until a necking operation is initiated (a), and a diameter of a neck portion (C).

The tip end 3 of the silicon seed crystal of which a body 2 has a diameter of 14 mm was tapered to be a conical shape having vertical angle of 20 °, and the surface of the silicon seed crystal was treated with a mixed acid to be etched to a depth of approximately 400 µm. The resultant silicon seed crystal 1 was fitted into a seed crystal holder 6, and a monocrystal ingot having a diameter of 150 mm (6 inches) was grown. Rate of success in making a crystal dislocation free was examined for the resultant monocrystal ingot.

The seeding method was performed as follows. First, after being kept at the position of 5 mm above the silicon melt for five minutes, the above mentioned silicon seed crystal 1 was lowered at the rate of 2.0 mm/min, and the tip end thereof was dipped into the melt and melted down therein in such a way that the part having a certain length from the lower end of the seed crystal can be dipped in the melt, and the diameter of the end of the seed crystal 3 after melting the tip end can be (B) mm (B ≧ 2C). After the silicon seed crystal 1 was kept at the position for (a) minutes, necking was initiated, and continued in such way that a tapered necking part 4 having a inverted cone like shape can be formed until the diameter of the part reaches the predetermined value (C). Then, the neck portion in a cylindrical shape 5 was formed, followed by pulling a crystal with increasing of the diameter thereof. Finally, the monocrystal silicon ingot was pulled at a predetermined pulling rate.

Rate of success in making a crystal dislocation free during growing of the silicon monocrystal thus manufactured is shown in Table 1. The term " rate of success in making a crystal dislocation free" (%) (hereinafter occasionally referred to as DF rate) means percentage of the number of the monocrystal ingot having no slip dislocation to the total number of the pulled monocrystal ingots.

**Table 1**

| est No. | Shape of the seed crystal, Diameter A(mm) | Diameter after melting down B (mm) | Holding Time after Melting down a (min) | Diameter of neck portion C (mm) | Success rate (DF rate) (%) |
|---|---|---|---|---|---|
| 1 | Cylinder with sharp tip end, 14 | 14 | 5 | 6.5 | 90 |
| 2 | Cylinder with sharp tip end, 14 | 14 | 10 | 6.5 | 40 |
| 3 | Cylinder with sharp tip end, 14 | 6.5 | 5 | 6.5 | 50 |
| 4 | Cylinder with sharp tip end, 14 | 6.5 | 10 | 6.5 | 30 |
| 5 | Cylinder, 14 | 14 | 5 | 6.5 | 20 |

As shown in Table 1, the relation between the factors A to C, (a) and rate of success in making a crystal dislocation free is clear as follows.
(1) The diameter of the lower end of the seed crystal 3 after melting the tip end (B) has to be twice as large as the diameter of the neck portion (C) or more (compare the results of Test No. 1 with No. 3, and Test No. 2 with No. 4). Because, a tapered necking part has to be formed at an early stage by pulling the crystal with gradually decreasing the diameter in order to eliminate slip dislocation completely in the necking operation after melting down. If the neck portion in cylindrical shape having the same diameter as that after melting is formed without forming the tapered necking part, slip dislocation cannot be reduced, as confirmed also in other experiments.
(2) In the process that the tip end of the silicon seed crystal 3 is melted down into a melt, it is preferably that a holding time (a) after melting down of the seed crystal is 5 minutes or less and the necking operation is initiated immediately (compare the results of Test No. 1 with No. 2, and Test No. 3 with No. 4).

When the tip end of the seed crystal is melted at a temperature suitable for necking, and necking is initiated immediately after melting down ranging from 0 to 5 minutes, almost no slip dislocation newly generates, and slip dislocation is hardly increased, so that rate of success in making a crystal dislocation free can be further improved. If the holding time at the surface of the melt having high temperature is more than five minutes, slip dislocation newly generates. If the seed crystal having slip dislocation is kept under high temperature, slip dislocation increases.

Fig. 2 shows the result of the experiment examining the relation between a holding time after melting down of the seed crystal and a slip dislocation density.

The term "dislocation density" as used herein means a pit density observed in the center of the section of the seed crystal, which is obtained by cutting the seed crystal along the surface parallel to the axial direction of crystal growing, and performing preferential etching. The pit density interrelates to the number of generation of slip dislocation.

As shown in Fig. 2, longer holding time results in higher dislocation density. When dislocation density increases, slip dislocation is hardly eliminated in the subsequent necking process.

Test No. 5 in Table 1 is a comparative example, in which a necking operation was performed in the same manner as Test No. 1 except that there was used a seed crystal in a cylindrical shape having a diameter of 14 mm of which tip end is flat. When the seed crystal having no sharp tip is used and the neck is formed to be thick, the success rate is extremely lowered.

As described above, in the seeding method with thick necking using a seed crystal having a sharp tip end according to the present invention, two factors closely relate to rate of success in making a crystal dislocation free; one of which is that the diameter of the lower end of the seed crystal after melting the tip end (B) is twice as large as the diameter of the neck portion (C) or more, the other of which is a holding time (a) after melting down. By controlling the factors in an appropriate range, slip dislocation can be surely eliminated in a necking process, and slip dislocation hardly generates in the pulled crystal so that high rate of success in making a crystal dislocation free can be obtained with high reproducibility. The present invention is especially advantageous for growing the monocrystal ingot having a large diameter and high weight, and therefore, productivity and yield of the monocrystal ingot can be improved, and cost reduction can be achieved.

The seed crystal used for the seeding method with thick necking according to the present invention is preferably the seed crystal conventionally used for dislocation free seeding of which an end to be brought into contact with a silicon melt is a sharp tip end in the shape of a cone or a pyramid or a truncation thereof, and a body is in a shape of a cylinder (column) or a prism. Accordingly, the term "a seed crystal having a sharp tip" as used herein includes these seed crystals.

When there is used the silicon seed crystal in a cylindrical shape having diameter of 14 mm or more, a square rod shape having a side length of 14 mm or more, or a polygonal rod shape wherein a diameter of the inscribed circle in section is 14 mm or more as described above, the tapered necking part sufficient for eliminating slip dislocation can be formed between the seed crystal and the neck portion even if the diameter of the neck portion is thick as 5 mm or more. Accordingly, the method can cope with the tendency of the monocrystal ingot to be larger and heavier.

The tip end of these seed crystals preferably have a vertical angle of 28 ° or less, thereby a thermal stress can be relaxed on seeding, resulting in significant reduction or elimination of generation of slip dislocation. Moreover, increasing of slip dislocation can be surely prevented also on melting down of the seed crystal, since the diameter thereof changes slowly.

The present invention is not limited to the above-described embodiment. The above-described embodiment is a mere example, and those having the substantially same structure as that described in the appended claims and providing the similar action and effects are included in the scope of the present invention.

For example, in the above-described embodiment, the silicon monocrystal ingot having a diameter of 150 mm (6 inches) was grown. However, the method of the present invention can sufficiently cope with a silicon monocrystal ingot having further larger diameter as from 200 mm (8 inches) to 400 mm (16 inches) which has been used in recent years.

Moreover, the method of the present invention can be applied not only for a Czochralski method but also for MCZ method (Magnetic field applied Czochralski crystal growth method) in which magnetic field is applied when the silicon monocrystal is pulled. Namely, the term "a Czochralski method" includes not only general Czochralski method but also MCZ method.

## Claims

1. A method of producing a silicon monocrystal which comprises preparing a silicon seed crystal (1) having a sharp tip end, and melting down part of the silicon seed crystal (1) from the tip end to a position having a predetermined thickness (B), followed by performing a necking operation to form a tapered necking part (4) and a cylindrical neck portion (5), and subsequently pulling a monocrystal ingot after increasing a diameter, **characterised in that**:
a diameter (A) or a side length of a body (2) of said seed crystal (1) is 14 mm or more;
said part of the seed crystal to be melted down is a part from the tip end to a position in which the thickness (B) is twice as large as the diameter (C) of the neck portion (5) to be formed or more;
said necking operation is initiated within 5 minutes after said part of the silicon seed crystal (1) is melted down into the melt; and
said necking operation is performed in such a way that the tapered necking part (4) is formed at an early stage by pulling a crystal with its diameter gradually decreasing to a minimum diameter of 5 mm or more, then forming the neck portion (5), and subsequently increasing the diameter of the crystal and pulling the monocrystal ingot.

## Patentansprüche

1. Ein Verfahren zum Herstellen eines Siliziumeinkristalls, das das Vorbereiten eines Siliziumimpfkristalls (1), der ein scharfes Spitzenende aufweist, und das Einschmelzen eines Teils des Siliziumimpfkristalls (1) von dem Spitzenende zu einer Position mit einer vorbestimmten Dicke (B), gefolgt vom Durchführen eines Halsbildungsvorgangs, um einen zugespitzten Halsbildungsteil (4) und einen zylindrischen Halsabschnitt (5) zu bilden, und dem anschließenden Ziehen eines Einkristallblocks nach der Vergrößerung eines Durchmessers, beinhaltet, **dadurch gekennzeichnet, dass**:
ein Durchmesser (A) oder eine Seitenlänge eines Körpers (2) des Impfkristalls (1) 14 mm öder mehr beträgt;
der einzuschmelzende Teil des Impfkristalls ein Teil von dem Spitzenende zu einer Position ist, an der die Dicke (B) zwei mal so groß wie der Durchmesser (C) des zu bildenden Halsabschnitts (5) oder mehr ist;
der Halsbildungsvorgang innerhalb von 5 Minuten nach dem Einschmelzen des Teils des Siliziumimpfkristalls (1) in die Schmelze begonnen wird; und
der Halsbildungsvorgang so durchgeführt wird, dass der zugespitzte Halsbildungsteil (4) frühzeitig gebildet wird, indem ein Kristall gezogen wird, wobei sich sein Durchmesser allmählich zu einem Mindestdurchmesser von 5 mm oder mehr verringert, dann der Halsabschnitt (5) gebildet wird und anschließend der Durchmesser des Kristalls vergrößert und der Einkristallblock gezogen wird.

## Revendications

1. Un procédé de production d'un monocristal de silicium comportant la préparation d'un germe cristallin de silicium (1) ayant une extrémité de bout pointue et la fusion d'une partie du germe cristallin de silicium (1) depuis l'extrémité de bout jusqu'à un endroit ayant une épaisseur prédéterminée (B), suivies de la réalisation d'une opération de striction afin de former une partie d'étranglement effilée (4) et une portion de collet cylindrique (5), et du tirage, par la suite, d'un lingot de monocristal après l'accroissement d'un diamètre, **caractérisé en ce que**:
un diamètre (A) ou une longueur latérale d'un corps (2) dudit germe cristallin (1) est de 14 mm ou plus ;
ladite partie du germe cristallin devant être fondue est une partie allant de l'extrémité de bout à un endroit où l'épaisseur (B) est deux fois plus grande que le diamètre (C) de la portion de collet (5) devant être formée ou plus ;
ladite opération de striction est commencée dans les 5 minutes qui suivent la fusion de ladite partie du germe cristallin de silicium (1) dans le bain de fusion ; et
ladite opération de striction est réalisée d'une manière telle que la partie d'étranglement effilée (4) soit formée dès le début en tirant un cristal tout en diminuant progressivement son diamètre jusqu'à un diamètre minimum de 5 mm ou plus, puis en formant la portion de collet (5), et ensuite en accroissant le diamètre du cristal et en tirant le lingot de monocristal.
